# EUROPEAN PATENT APPLICATION

(11) **EP 4 105 973 A1**
(43) Date of publication of application: **21.12.2022**
(21) Application number: 22169695.8
(22) Date of filing: 25.04.2022
(51) Int. Cl.: H01L 21/768, H01L 23/522, H01L 23/528

(54) **STENT AND WRAP VIA ON TRENCH CONTACT**

(30) Priority: 14.06.2021 US 202117346964
(71) Applicant: INTEL Corporation, Santa Clara, CA 95054 (US)
(72) Inventor: GULER, Leonard P., Hillsboro, 97124 (US); WALLACE, Charles H., Portland, 97212 (US); GHANI, Tahir, Portland, 97229 (US)
(74) Representative: Goddar, Heinz J.

(57) **Abstract**

Embodiments disclosed herein include integrated circuit structures and methods of forming such structures. In an embodiment, an integrated circuit structure comprises plurality of gate structures above a substrate, a plurality of conductive trench contact structures alternating with the plurality of gate structures, a plurality of dielectric spacers, a corresponding one of the plurality of dielectric spacers between adjacent ones of the plurality of gate structures and the plurality of conductive trench contact structures, and a plurality of conductive vias, individual ones of the plurality of conductive vias on corresponding ones of the plurality of conductive trench contact structures, wherein bottommost surfaces of the conductive vias are below topmost surfaces of the plurality of conductive trench contact structures.

## Description

### TECHNICAL FIELD

Embodiments of the disclosure are in the field of advanced integrated circuit structure fabrication and, in particular, conductive vias with increased surface area for trench contacts or gate contacts.

### BACKGROUND

For the past several decades, the scaling of features in integrated circuits has been a driving force behind an ever-growing semiconductor industry. Scaling to smaller and smaller features enables increased densities of functional units on the limited real estate of semiconductor chips. For example, shrinking transistor size allows for the incorporation of an increased number of memory or logic devices on a chip, lending to the fabrication of products with increased capacity. The drive for ever-more capacity, however, is not without issue. The necessity to optimize the performance of each device becomes increasingly significant.

Variability in conventional and currently known fabrication processes may limit the possibility to further extend them into the 10 nanometer node or sub-10 nanometer node range. Consequently, fabrication of the functional components needed for future technology nodes may require the introduction of new methodologies or the integration of new technologies in current fabrication processes or in place of current fabrication processes.

In the manufacture of integrated circuit devices, multi-gate transistors, such as tri-gate transistors, have become more prevalent as device dimensions continue to scale down. Tri-gate transistors are generally fabricated on either bulk silicon substrates or silicon-on-insulator substrates. In some instances, bulk silicon substrates are preferred due to their lower cost and compatibility with the existing high-yielding bulk silicon substrate infrastructure.

Scaling multi-gate transistors has not been without consequence, however. As the dimensions of these fundamental building blocks of microelectronic circuitry are reduced and as the sheer number of fundamental building blocks fabricated in a given region is increased, the constraints on the semiconductor processes used to fabricate these building blocks have become overwhelming.

### BRIEF DESCRIPTION OF THE DRAWINGS

Figures 1A-1D are cross-sectional illustrations depicting operations in a process to fabricate vias for trench contacts with increased surface area that reduces contact resistance, in accordance with an embodiment.
Figures 2A and 2B are cross-sectional illustrations depicting operations in a process to fabricate vias for trench contacts where the via wraps around a corner of the trench contact, in accordance with an embodiment.
Figures 3A and 3B are cross-sectional illustrations depicting operations in a process to fabricate vias for trench contacts where the via fills a recess in the trench contact, in accordance with an embodiment.
Figures 4A-4E are cross-sectional illustrations depicting operations in a process to fabricate a via to a conductive structure with increased surface area that reduces contact resistance, in accordance with an embodiment.
Figures 5A and 5B are cross-sectional illustrations depicting operations in a process to fabricate vias to conductive structures where the via fills a recess in the conductive structure, in accordance with an embodiment.
Figures 6A and 6B are cross-sectional illustrations depicting operations in a process to fabricate vias to conductive structures where the via wraps around a corner of the conductive structure, in accordance with an embodiment.
Figure 7 illustrates a computing device in accordance with one implementation of the disclosure.
Figure 8 illustrates an interposer that includes one or more embodiments of the disclosure.
Figure 9 is an isometric view of a mobile computing platform employing an IC fabricated according to one or more processes described herein or including one or more features described herein, in accordance with an embodiment of the present disclosure.
Figure 10 illustrates a cross-sectional view of a flip-chip mounted die, in accordance with an embodiment of the present disclosure.

### DESCRIPTION OF THE EMBODIMENTS

Via structures with interfaces with the underlying conductive structure that have increased surface area, and methods of fabricating via structures with interfaces with the underlying conductive structure that have increased surface area, are described. In the following description, numerous specific details are set forth, such as specific integration and material regimes, in order to provide a thorough understanding of embodiments of the present disclosure. It will be apparent to one skilled in the art that embodiments of the present disclosure may be practiced without these specific details. In other instances, well-known features, such as integrated circuit design layouts, are not described in detail in order to not unnecessarily obscure embodiments of the present disclosure. Furthermore, it is to be appreciated that the various embodiments shown in the Figures are illustrative representations and are not necessarily drawn to scale.

The following detailed description is merely illustrative in nature and is not intended to limit the embodiments of the subject matter or the application and uses of such embodiments. As used herein, the word "exemplary" means "serving as an example, instance, or illustration." Any implementation described herein as exemplary is not necessarily to be construed as preferred or advantageous over other implementations. Furthermore, there is no intention to be bound by any expressed or implied theory presented in the preceding technical field, background, brief summary or the following detailed description.

This specification includes references to "one embodiment" or "an embodiment." The appearances of the phrases "in one embodiment" or "in an embodiment" do not necessarily refer to the same embodiment. Particular features, structures, or characteristics may be combined in any suitable manner consistent with this disclosure.

Terminology. The following paragraphs provide definitions or context for terms found in this disclosure (including the appended claims):

"Comprising." This term is open-ended. As used in the appended claims, this term does not foreclose additional structure or operations.

"Configured To." Various units or components may be described or claimed as "configured to" perform a task or tasks. In such contexts, "configured to" is used to connote structure by indicating that the units or components include structure that performs those task or tasks during operation. As such, the unit or component can be said to be configured to perform the task even when the specified unit or component is not currently operational (e.g., is not on or active). Reciting that a unit or circuit or component is "configured to" perform one or more tasks is expressly intended not to invoke 35 U.S.C. §112, sixth paragraph, for that unit or component.

"First," "Second," etc. As used herein, these terms are used as labels for nouns that they precede, and do not imply any type of ordering (e.g., spatial, temporal, logical, etc.).

"Coupled" - The following description refers to elements or nodes or features being "coupled" together. As used herein, unless expressly stated otherwise, "coupled" means that one element or node or feature is directly or indirectly joined to (or directly or indirectly communicates with) another element or node or feature, and not necessarily mechanically.

In addition, certain terminology may also be used in the following description for the purpose of reference only, and thus are not intended to be limiting. For example, terms such as "upper", "lower", "above", and "below" refer to directions in the drawings to which reference is made. Terms such as "front", "back", "rear", "side", "outboard", and "inboard" describe the orientation or location or both of portions of the component within a consistent but arbitrary frame of reference which is made clear by reference to the text and the associated drawings describing the component under discussion. Such terminology may include the words specifically mentioned above, derivatives thereof, and words of similar import.

"Inhibit" - As used herein, inhibit is used to describe a reducing or minimizing effect. When a component or feature is described as inhibiting an action, motion, or condition it may completely prevent the result or outcome or future state completely. Additionally, "inhibit" can also refer to a reduction or lessening of the outcome, performance, or effect which might otherwise occur. Accordingly, when a component, element, or feature is referred to as inhibiting a result or state, it need not completely prevent or eliminate the result or state.

Embodiments described herein may be directed to front-end-of-line (FEOL) semiconductor processing and structures. FEOL is the first portion of integrated circuit (IC) fabrication where the individual devices (e.g., transistors, capacitors, resistors, etc.) are patterned in the semiconductor substrate or layer. FEOL generally covers everything up to (but not including) the deposition of metal interconnect layers. Following the last FEOL operation, the result is typically a wafer with isolated transistors (e.g., without any wires).

Embodiments described herein may be directed to back-end-of-line (BEOL) semiconductor processing and structures. BEOL is the second portion of IC fabrication where the individual devices (e.g., transistors, capacitors, resistors, etc.) get interconnected with wiring on the wafer, e.g., the metallization layer or layers. BEOL includes contacts, insulating layers (dielectrics), metal levels, and bonding sites for chipto-package connections. In the BEOL part of the fabrication stage contacts (pads), interconnect wires, vias and dielectric structures are formed. For modern IC processes, more than 10 metal layers may be added in the BEOL.

Embodiments described below may be applicable to FEOL processing and structures, BEOL processing and structures, or both FEOL and BEOL processing and structures. In particular, although an exemplary processing scheme may be illustrated using a FEOL processing scenario, such approaches may also be applicable to BEOL processing. Likewise, although an exemplary processing scheme may be illustrated using a BEOL processing scenario, such approaches may also be applicable to FEOL processing.

In accordance with an embodiment of the present disclosure, conductive via structures and processes are described. In accordance with an embodiment of the present disclosure, conductive via structures have an increased interface surface area with the underlying conductive structure. The increase in the surface area of the interface allows for a reduction in the contact resistance at the interface. Reducing the contact resistance is an ever growing challenge as feature sizes continue to scale down. One or more embodiments of the present disclosure include forming a recess in the underlying conductive structure and a recess in the adjacent dielectric spacer, and filling the recesses with the conductive via. One or more embodiments of the present disclosure include forming a recess in the underlying conductive structure, and filling the recess with the conductive via. One or more embodiments of the present disclosure include forming a recess in a dielectric spacer adjacent to the underlying conductive structure, and filling the recess with the conductive via. In such an embodiment, the conductive via wraps around a corner of the underlying conductive structure. In accordance with one or more embodiments, the underlying conductive structure is a gate contact or a trench contact.

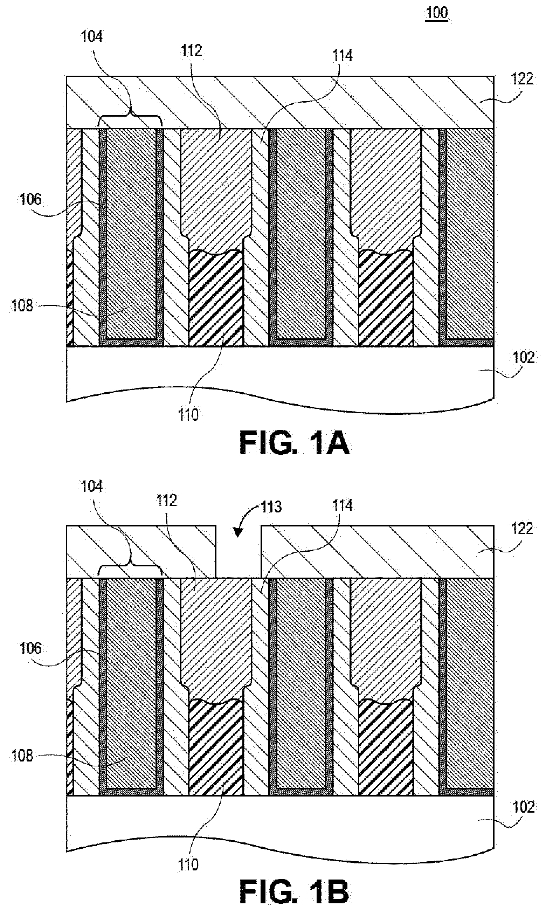

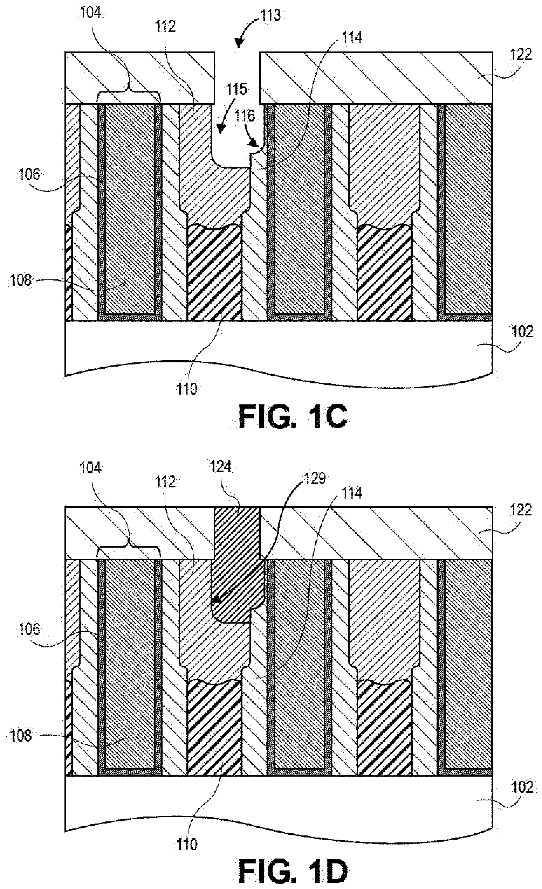

In an exemplary processing scheme, Figures 1A-1D illustrate cross-sectional views illustrating various operations in a method of fabricating conductive via structures with increased interface surface area with the underlying trench contact, in accordance with an embodiment of the present disclosure.

Referring to Figure 1A, a starting structure 100 includes a plurality of gate structures 104 above a substrate 102. The gate structures 104 can each include a gate electrode 108 and a gate dielectric 106. Dielectric spacers 114 are formed along sides of the gate structures 104. The gate structures 104 have an uppermost surface that is co-planar with an uppermost surface of the dielectric spacers 114. Conductive trench contact structures 112 are between the dielectric spacers 114 of adjacent gate structures 104. The conductive trench contact structures 112 are on corresponding epitaxial source or drain structures 110. The conductive trench contact structures 112 have an uppermost surface co-planar with an uppermost surface of the dielectric spacers 114. An insulating layer 122, such as an interlayer dielectric (ILD) is provide over the conductive trench contact structures 112, over the dielectric spacers 114, and over the gate structure 104.

Referring to Figure 1B, an opening 113 is formed through the insulating layer 122. The opening 113 may be formed with a lithographic patterning process. In an embodiment, the opening 113 is positioned over one of the conductive trench contact structures 112 and over one of the dielectric spacers 114. That is, the opening 113 exposes two different material layers.

Referring to Figure 1C, the exposed conductive trench contact structure 112 and the exposed dielectric spacer 114 are etched with an etching process. The etching process may be an anisotropic etching process. In an embodiment, a single etchant is used to etch the conductive trench contact structure 112 and the dielectric spacer 114. In such an embodiment, the etch rate of the conductive trench contact structure 112 may be different than the etch rate of the dielectric spacer 114. For example, as shown in Figure 1C, a recess 115 into the conductive trench contact structure 112 is deeper than a recess 116 into the dielectric spacer 114. In other embodiments, separate etching chemistries are used to etch the recess 115 and the recess 116. Additionally, in some embodiments, a depth of the recess 115 may be substantially equal to a depth of the recess 116. As shown, the recess 115 may undercut a portion of the insulating layer 122. An undercut of the insulating layer 122 may also be provided by the recess 116.

Referring to Figure ID, a conductive via 124 is disposed in the recesses 115 and the recess 116. The conductive via 124 has an interface 129 with the conductive trench contact structure 112. As shown in Figure ID, the interface 129 has a larger surface area than if the via landed only on the uppermost surface of the conductive trench contact structure 112, as is common in existing devices. Additionally, the recess 116 provides additional room for added volume of the conductive via 124. As such, the recess 115 and the recess 116 are easier to fill with conductive materials, than would be the case if the recess 116 were omitted.

As shown in Figure ID, a bottommost surface of the conductive via 124 is positioned below an uppermost surface of the conductive trench contact structure 112. Additionally, the conductive via 124 may have a stepped bottommost surface. The stepped shape can be the result of recess 115 and recess 116 being formed to different depths within the structure. Due to the undercutting of the insulating layer 122, portions of the conductive via 124 may directly contact a bottom surface of the insulating layer 122.

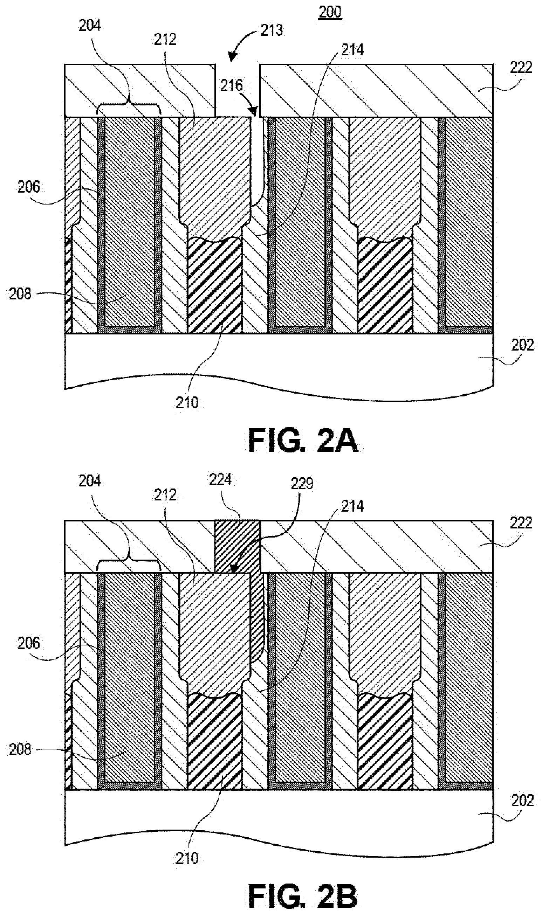

Referring now to Figures 2A and 2B, cross-sectional views illustrating various operations in a method of fabricating conductive via structures with increased interface surface area with the underlying trench contact are shown, in accordance with an additional embodiment of the present disclosure.

Referring now to Figure 2A, a starting structure 200 includes a plurality of gate structures 204 above a substrate 202. The gate structures 204 can each include a gate electrode 208 and a gate dielectric 206. Dielectric spacers 214 are formed along sides of the gate structures 204. The gate structures 204 have an uppermost surface that is co-planar with an uppermost surface of the dielectric spacers 214. Conductive trench contact structures 212 are between the dielectric spacers 214 of adjacent gate structures 204. The conductive trench contact structures 212 are on corresponding epitaxial source or drain structures 210. The conductive trench contact structures 212 have an uppermost surface co-planar with an uppermost surface of the dielectric spacers 214. An insulating layer 222, such as an ILD is provide over the conductive trench contact structures 212, over the dielectric spacers 214, and over the gate structure 204.

As shown in Figure 2A, an opening 213 is formed through the insulating layer 222. The opening 213 exposes a portion of the conductive trench contact structure 212 and a portion of the dielectric spacer 214. A recess 216 may be formed into the dielectric spacer 214. For example, an etching process that is selective to the dielectric spacer 214 over the conductive trench contact structure 212 is used to selectively remove portions of the dielectric spacer 214.

Referring now to Figure 2B, a conductive via 224 is disposed in the recess 216. The conductive via 224 contacts a topmost surface of the conductive trench contact structure 212 and a sidewall of the conductive trench contact structure 212. That is, the conductive via 224 may wrap around a corner of the conductive trench contact structure 212. As such, an interface 229 between the conductive via 224 and the conductive trench contact structure 212 is increased over traditional contact architectures where the conductive via 224 lands only on the top surface of the conductive trench contact structure 212.

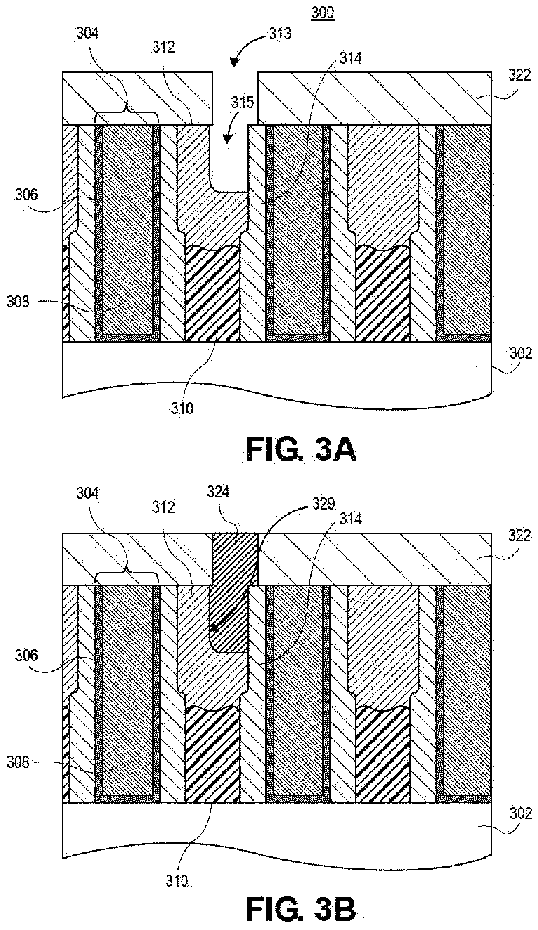

Referring now to Figures 3A and 3B, cross-sectional views illustrating various operations in a method of fabricating conductive via structures with increased interface surface area with the underlying trench contact are shown, in accordance with an additional embodiment of the present disclosure.

Referring now to Figure 3A, a starting structure 300 includes a plurality of gate structures 304 above a substrate 302. The gate structures 304 can each include a gate electrode 308 and a gate dielectric 306. Dielectric spacers 314 are formed along sides of the gate structures 304. The gate structures 304 have an uppermost surface that is co-planar with an uppermost surface of the dielectric spacers 314. Conductive trench contact structures 312 are between the dielectric spacers 314 of adjacent gate structures 304. The conductive trench contact structures 312 are on corresponding epitaxial source or drain structures 310. The conductive trench contact structures 312 have an uppermost surface co-planar with an uppermost surface of the dielectric spacers 314. An insulating layer 322, such as an ILD is provide over the conductive trench contact structures 312, over the dielectric spacers 314, and over the gate structure 304.

As shown in Figure 3A, an opening 313 is formed through the insulating layer 322. The opening 313 exposes a portion of the conductive trench contact structure 312 and a portion of the dielectric spacer 314. A recess 315 may be formed into the conductive trench contact structure 312. For example, an etching process that is selective to the conductive trench contact structure 312 over the dielectric spacer 314 is used to selectively remove portions of the conductive trench contact structure 312.

Referring now to Figure 3B, a conductive via 324 is disposed in the recess 315. Due to the recess 315, the conductive via 324 has an interface 329 with the conductive trench contact structure 312 that is greater in surface area than if the conductive via 324 landed on the topmost surface of the conductive trench contact structure 312. As shown, the conductive via 324 may wrap around a corner of the dielectric spacer 314. That is, a portion of the conductive via 324 may be in contact with a topmost surface of the spacer 314, and a portion of the conductive via 324 may be in contact with a sidewall of the spacer 314.

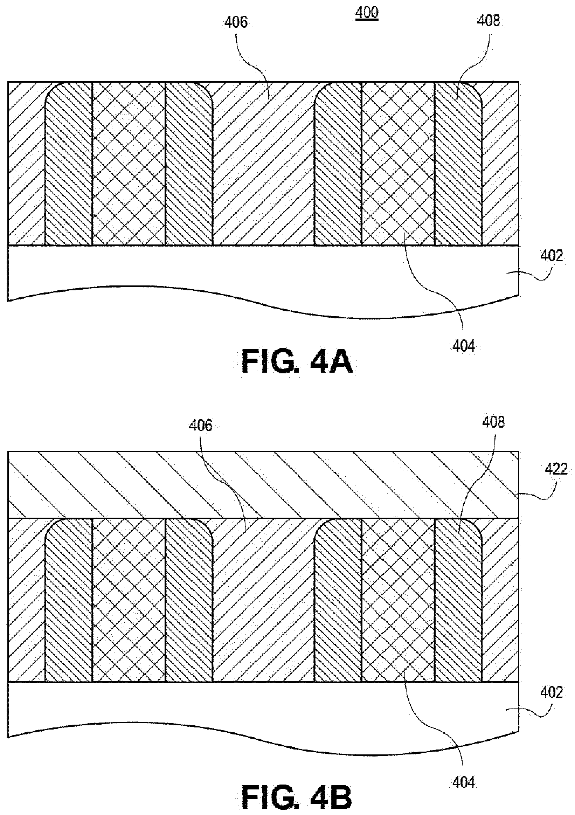

In accordance with one or more embodiments of the present disclosure, a process flow is implemented which involves recessing conductive features to provide increased interface area with a conductive via. The process can enable the fabrication of contacts with reduced contact resistance for device scaling. Although described extensively with respect to forming conductive via structures for conductive trench contacts, embodiments described herein can similarly be implemented to fabricate vias with increased interface area for gate contacts. As a more generic processing scheme, Figures 4A-4D illustrate cross-sectional views illustrating various operations in a method of fabricating conductive vias with increased interface area for conductive trench contacts or gate contacts, in accordance with an embodiment of the present disclosure.

Referring to Figure 4A, a starting structure 400 includes a plurality of conductive structures 404 above a substrate 402. Dielectric spacers 408 are formed along sides of the conductive structures 404. The conductive structures 404 have an uppermost surface co-planar with an uppermost surface of the dielectric spacers 408. Conductive structures 406 are between the dielectric spacers 408 of adjacent conductive structures 404. The conductive structures 406 have an uppermost surface co-planar with an uppermost surface of the dielectric spacers 408.

Referring to Figure 4B, an insulating layer 422 is provided over the conductive structures 404, the dielectric spacers 408, and the conductive structures 406. The insulating layer 422 may be an ILD in some embodiments.

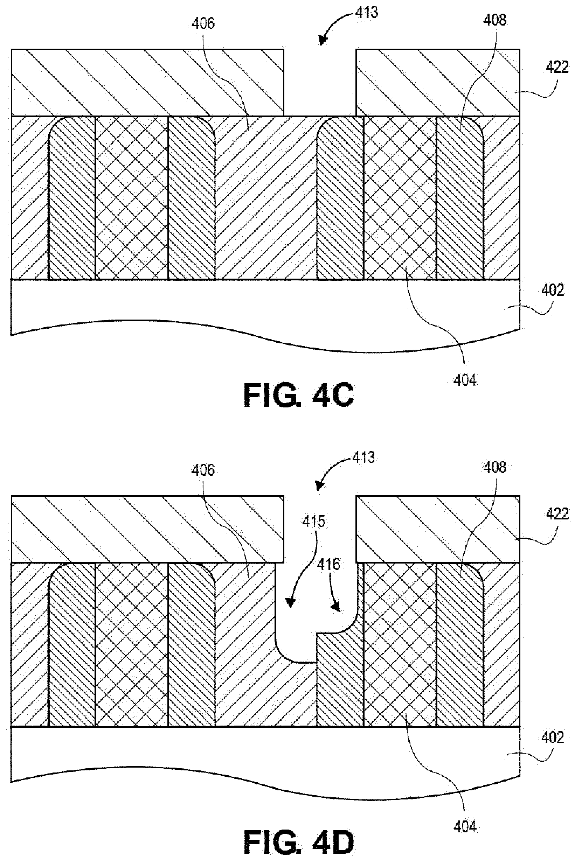

Referring to Figure 4C, an opening 413 is formed through the insulating layer 422. The opening 413 may expose portions of the conductive structure 406 and a portion of a dielectric spacer 408. The opening 413 may be formed with a lithographic patterning process.

Referring to Figure 4D, recess 415 and recess 416 are formed below the opening 413. The recess 415 is formed into the conductive structure 406, and the recess 416 is formed into the dielectric spacer 408. In an embodiment, a single etching process is used to form the recesses 415 and 416. The single etching process may result in the uneven etching of the recess 415 and the recess 416. For example, recess 415 may be deeper than the recess 416. In other embodiments, the recesses 415 and 416 may have substantially similar depths, or the recess 416 may be deeper than the recess 415. In an embodiment, the recesses 415 and 416 may also undercut the opening 413.

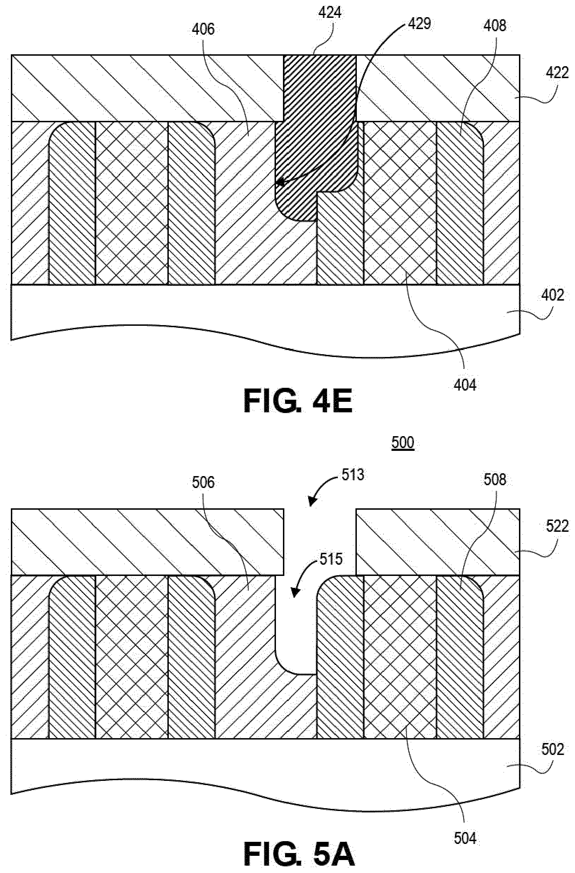

Referring now to Figure 4E, a via 424 is disposed in the recesses 415 and 416. The via 424 may have an interface 429 with the conductive structure 406. The interface 429 has an area that is larger than an area of an interface if the via 424 landed only on a topmost surface of the conductive structure 406. As such, contact resistance is reduced. In an embodiment, the via 424 has a stepped bottom surface. The stepped surface results from the different depths of the recesses 415 and 416. Additionally, the via 424 may contact a bottommost surface of the insulating layer 422 due to the undercut of the opening 413.

With reference again to Figures 4A-4E, conductive structures 404 are gate structures, and conductive structures 406 are conductive trench contact structures. In another embodiment, conductive structures 406 are gate structures, and conductive structures 404 are conductive trench contact structures.

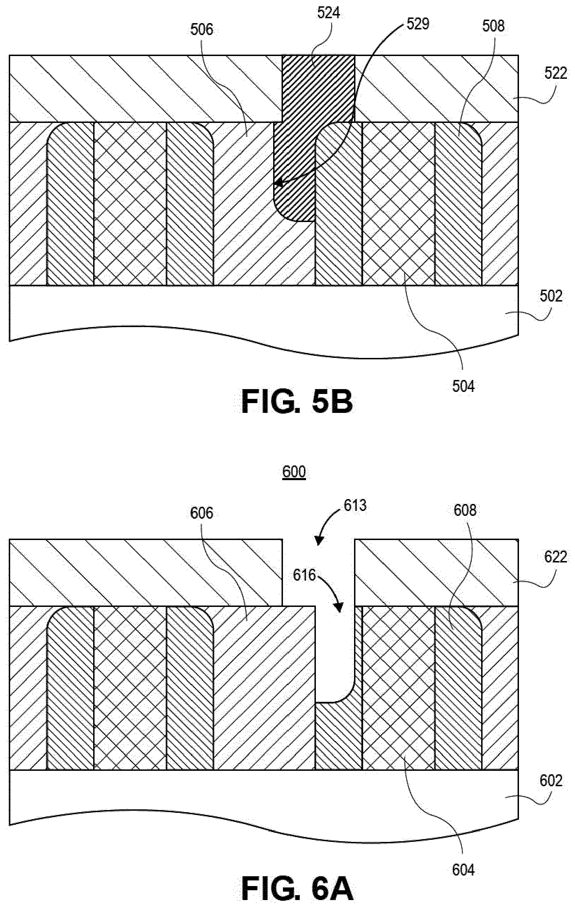

Referring now to Figures 5A and 5B, a generic process flow with a via in accordance with an additional embodiment is shown. Figure 5A illustrates a starting structure 500 that includes a plurality of conductive structures 504 above a substrate 502. Dielectric spacers 508 are formed along sides of the conductive structures 504. The conductive structures 504 have an uppermost surface co-planar with an uppermost surface of the dielectric spacers 508. Conductive structures 506 are between the dielectric spacers 508 of adjacent conductive structures 504. The conductive structures 506 have an uppermost surface co-planar with an uppermost surface of the dielectric spacers 508.

As shown in Figure 5A, an opening 513 is provided through an insulating layer 522. A recess 515 into the conductive structure 506 is below the opening 513. The recess 515 may result from an etching process that is selective to the conductive structure 506 over the dielectric spacer 508.

Referring now to Figure 5B, a via 524 is disposed in the recess 515. The via 524 may have an interface 529 with the conductive structure 506. The interface 529 has an area that is larger than if the via 524 landed on a top surface of the conductive structure 506. As such, the contact resistance is reduced.

With reference again to Figures 5A and 5B, conductive structures 504 are gate structures, and conductive structures 506 are conductive trench contact structures. In another embodiment, conductive structures 506 are gate structures, and conductive structures 504 are conductive trench contact structures.

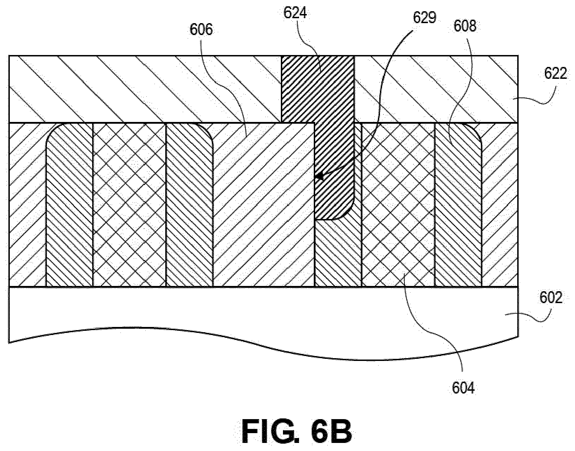

Referring now to Figures 6A and 6B, a generic process flow with a via in accordance with an additional embodiment is shown, in accordance with an embodiment. Figure 6A illustrates a starting structure 600 that includes a plurality of conductive structures 604 above a substrate 602. Dielectric spacers 608 are formed along sides of the conductive structures 604. The conductive structures 604 have an uppermost surface co-planar with an uppermost surface of the dielectric spacers 608. Conductive structures 606 are between the dielectric spacers 608 of adjacent conductive structures 604. The conductive structures 606 have an uppermost surface co-planar with an uppermost surface of the dielectric spacers 608.

As shown in Figure 6A, an opening 613 is provided through an insulating layer 622. A recess 616 into the dielectric spacer 608 is below the opening 613. The recess 616 may result from an etching process that is selective to the dielectric spacer 608 over the conductive structure 606.

Referring now to Figure 6B, a via 624 is disposed in the recess 616. The via 624 may have an interface 629 with the conductive structure 606. The interface 629 has an area that is larger than if the via 624 landed on a top surface of the conductive structure 606. As such, the contact resistance is reduced. In an embodiment, the via 624 may be referred to as wrapping around a corner of the conductive structure 606.

With reference again to Figures 6A and 6B, conductive structures 604 are gate structures, and conductive structures 606 are conductive trench contact structures. In another embodiment, conductive structures 606 are gate structures, and conductive structures 604 are conductive trench contact structures.

As described throughout the present application, a substrate may be composed of a semiconductor material that can withstand a manufacturing process and in which charge can migrate. In an embodiment, a substrate is described herein is a bulk substrate composed of a crystalline silicon, silicon/germanium or germanium layer doped with a charge carrier, such as but not limited to phosphorus, arsenic, boron or a combination thereof, to form an active region. In one embodiment, the concentration of silicon atoms in such a bulk substrate is greater than 97%. In another embodiment, a bulk substrate is composed of an epitaxial layer grown atop a distinct crystalline substrate, e.g. a silicon epitaxial layer grown atop a boron-doped bulk silicon mono-crystalline substrate. A bulk substrate may alternatively be composed of a group III-V material. In an embodiment, a bulk substrate is composed of a group III-V material such as, but not limited to, gallium nitride, gallium phosphide, gallium arsenide, indium phosphide, indium antimonide, indium gallium arsenide, aluminum gallium arsenide, indium gallium phosphide, or a combination thereof. In one embodiment, a bulk substrate is composed of a group III-V material and the charge-carrier dopant impurity atoms are ones such as, but not limited to, carbon, silicon, germanium, oxygen, sulfur, selenium or tellurium.

As described throughout the present application, isolation regions such as shallow trench isolation regions or sub-fin isolation regions may be composed of a material suitable to ultimately electrically isolate, or contribute to the isolation of, portions of a permanent gate structure from an underlying bulk substrate or to isolate active regions formed within an underlying bulk substrate, such as isolating fin active regions. For example, in one embodiment, an isolation region is composed of one or more layers of a dielectric material such as, but not limited to, silicon dioxide, silicon oxy-nitride, silicon nitride, carbon-doped silicon nitride, or a combination thereof.

As described throughout the present application, gate lines or gate structures may be composed of a gate electrode stack which includes a gate dielectric layer and a gate electrode layer. In an embodiment, the gate electrode of the gate electrode stack is composed of a metal gate and the gate dielectric layer is composed of a high-k material. For example, in one embodiment, the gate dielectric layer is composed of a material such as, but not limited to, hafnium oxide, hafnium oxy-nitride, hafnium silicate, lanthanum oxide, zirconium oxide, zirconium silicate, tantalum oxide, barium strontium titanate, barium titanate, strontium titanate, yttrium oxide, aluminum oxide, lead scandium tantalum oxide, lead zinc niobate, or a combination thereof. Furthermore, a portion of gate dielectric layer may include a layer of native oxide formed from the top few layers of a semiconductor substrate. In an embodiment, the gate dielectric layer is composed of a top high-k portion and a lower portion composed of an oxide of a semiconductor material. In one embodiment, the gate dielectric layer is composed of a top portion of hafnium oxide and a bottom portion of silicon dioxide or silicon oxy-nitride. In some implementations, a portion of the gate dielectric is a "U"-shaped structure that includes a bottom portion substantially parallel to the surface of the substrate and two sidewall portions that are substantially perpendicular to the top surface of the substrate.

In one embodiment, a gate electrode is composed of a metal layer such as, but not limited to, metal nitrides, metal carbides, metal silicides, metal aluminides, hafnium, zirconium, titanium, tantalum, aluminum, ruthenium, palladium, platinum, cobalt, nickel or conductive metal oxides. In a specific embodiment, the gate electrode is composed of a non-workfunction-setting fill material formed above a metal workfunction-setting layer. The gate electrode layer may consist of a P-type workfunction metal or an N-type workfunction metal, depending on whether the transistor is to be a PMOS or an NMOS transistor. In some implementations, the gate electrode layer may consist of a stack of two or more metal layers, where one or more metal layers are workfunction metal layers and at least one metal layer is a conductive fill layer. For a PMOS transistor, metals that may be used for the gate electrode include, but are not limited to, ruthenium, palladium, platinum, cobalt, nickel, and conductive metal oxides, e.g., ruthenium oxide. A P-type metal layer will enable the formation of a PMOS gate electrode with a workfunction that is between about 4.9 eV and about 5.2 eV. For an NMOS transistor, metals that may be used for the gate electrode include, but are not limited to, hafnium, zirconium, titanium, tantalum, aluminum, alloys of these metals, and carbides of these metals such as hafnium carbide, zirconium carbide, titanium carbide, tantalum carbide, and aluminum carbide. An N-type metal layer will enable the formation of an NMOS gate electrode with a workfunction that is between about 3.9 eV and about 4.2 eV. In some implementations, the gate electrode may consist of a "U"-shaped structure that includes a bottom portion substantially parallel to the surface of the substrate and two sidewall portions that are substantially perpendicular to the top surface of the substrate. In another implementation, at least one of the metal layers that form the gate electrode may simply be a planar layer that is substantially parallel to the top surface of the substrate and does not include sidewall portions substantially perpendicular to the top surface of the substrate. In further implementations of the disclosure, the gate electrode may consist of a combination of U-shaped structures and planar, non-U-shaped structures. For example, the gate electrode may consist of one or more U-shaped metal layers formed atop one or more planar, non-U-shaped layers.

As described throughout the present application, spacers associated with gate lines or electrode stacks may be composed of a material suitable to ultimately electrically isolate, or contribute to the isolation of, a permanent gate structure from adjacent conductive contacts, such as self-aligned contacts. For example, in one embodiment, the spacers are composed of a dielectric material such as, but not limited to, silicon dioxide, silicon oxy-nitride, silicon nitride, or carbon-doped silicon nitride.

In an embodiment, as used throughout the present description, interlayer dielectric (ILD) material is composed of or includes a layer of a dielectric or insulating material. Examples of suitable dielectric materials include, but are not limited to, oxides of silicon (e.g., silicon dioxide (SiO₂)), doped oxides of silicon, fluorinated oxides of silicon, carbon doped oxides of silicon, various low-k dielectric materials known in the arts, and combinations thereof. The interlayer dielectric material may be formed by techniques, such as, for example, chemical vapor deposition (CVD), physical vapor deposition (PVD), or by other deposition methods.

In an embodiment, as is also used throughout the present description, metal lines or interconnect line material (and via material) is composed of one or more metal or other conductive structures. A common example is the use of copper lines and structures that may or may not include barrier layers between the copper and surrounding ILD material. As used herein, the term metal includes alloys, stacks, and other combinations of multiple metals. For example, the metal interconnect lines may include barrier layers (e.g., layers including one or more of Ta, TaN, Ti or TiN), stacks of different metals or alloys, etc. Thus, the interconnect lines may be a single material layer, or may be formed from several layers, including conductive liner layers and fill layers. Any suitable deposition process, such as electroplating, chemical vapor deposition or physical vapor deposition, may be used to form interconnect lines. In an embodiment, the interconnect lines are composed of a conductive material such as, but not limited to, Cu, Al, Ti, Zr, Hf, V, Ru, Co, Ni, Pd, Pt, W, Ag, Au or alloys thereof. The interconnect lines are also sometimes referred to in the art as traces, wires, lines, metal, or simply interconnect.

In an embodiment, as is also used throughout the present description, hardmask materials are composed of dielectric materials different from the interlayer dielectric material. In one embodiment, different hardmask materials may be used in different regions so as to provide different growth or etch selectivity to each other and to the underlying dielectric and metal layers. In some embodiments, a hardmask layer includes a layer of a nitride of silicon (e.g., silicon nitride) or a layer of an oxide of silicon, or both, or a combination thereof. Other suitable materials may include carbonbased materials. In another embodiment, a hardmask material includes a metal species. For example, a hardmask or other overlying material may include a layer of a nitride of titanium or another metal (e.g., titanium nitride). Potentially lesser amounts of other materials, such as oxygen, may be included in one or more of these layers. Alternatively, other hardmask layers known in the arts may be used depending upon the particular implementation. The hardmask layers maybe formed by CVD, PVD, or by other deposition methods.

In an embodiment, as is also used throughout the present description, lithographic operations are performed using 193nm immersion lithography (i193), extreme ultra-violet (EUV) lithography or electron beam direct write (EBDW) lithography, or the like. A positive tone or a negative tone resist may be used. In one embodiment, a lithographic mask is a trilayer mask composed of a topographic masking portion, an anti-reflective coating (ARC) layer, and a photoresist layer. In a particular such embodiment, the topographic masking portion is a carbon hardmask (CHM) layer and the anti-reflective coating layer is a silicon ARC layer.

In an embodiment, approaches described herein may involve formation of a contact pattern which is very well aligned to an existing gate pattern while eliminating the use of a lithographic operation with exceedingly tight registration budget. In one such embodiment, this approach enables the use of intrinsically highly selective wet etching (e.g., versus dry or plasma etching) to generate contact openings. In an embodiment, a contact pattern is formed by utilizing an existing gate pattern in combination with a contact plug lithography operation. In one such embodiment, the approach enables elimination of the need for an otherwise critical lithography operation to generate a contact pattern, as used in other approaches. In an embodiment, a trench contact grid is not separately patterned, but is rather formed between poly (gate) lines. For example, in one such embodiment, a trench contact grid is formed subsequent to gate grating patterning but prior to gate grating cuts.

Furthermore, a gate stack structure may be fabricated by a replacement gate process. In such a scheme, dummy gate material such as polysilicon or silicon nitride pillar material, may be removed and replaced with permanent gate electrode material. In one such embodiment, a permanent gate dielectric layer is also formed in this process, as opposed to being carried through from earlier processing. In an embodiment, dummy gates are removed by a dry etch or wet etch process. In one embodiment, dummy gates are composed of polycrystalline silicon or amorphous silicon and are removed with a dry etch process including use of SF₆. In another embodiment, dummy gates are composed of polycrystalline silicon or amorphous silicon and are removed with a wet etch process including use of aqueous NH₄OH or tetramethylammonium hydroxide. In one embodiment, dummy gates are composed of silicon nitride and are removed with a wet etch including aqueous phosphoric acid.

In an embodiment, one or more approaches described herein contemplate essentially a dummy and replacement gate process in combination with a dummy and replacement contact process to arrive at structure. In one such embodiment, the replacement contact process is performed after the replacement gate process to allow high temperature anneal of at least a portion of the permanent gate stack. For example, in a specific such embodiment, an anneal of at least a portion of the permanent gate structures, e.g., after a gate dielectric layer is formed, is performed at a temperature greater than approximately 600 degrees Celsius. The anneal is performed prior to formation of the permanent contacts.

In some embodiments, the arrangement of a semiconductor structure or device places a gate contact over portions of a gate line or gate stack over isolation regions. However, such an arrangement may be viewed as inefficient use of layout space. In another embodiment, a semiconductor device has contact structures that contact portions of a gate electrode formed over an active region. In general, prior to (e.g., in addition to) forming a gate contact structure (such as a via) over an active portion of a gate and in a same layer as a trench contact via, one or more embodiments of the present disclosure include first using a gate aligned trench contact process. Such a process may be implemented to form trench contact structures for semiconductor structure fabrication, e.g., for integrated circuit fabrication. In an embodiment, a trench contact pattern is formed as aligned to an existing gate pattern. By contrast, other approaches typically involve an additional lithography process with tight registration of a lithographic contact pattern to an existing gate pattern in combination with selective contact etches. For example, another process may include patterning of a poly (gate) grid with separate patterning of contact features.

It is to be appreciated that pitch division processing and patterning schemes may be implemented to enable embodiments described herein or may be included as part of embodiments described herein. Pitch division patterning typically refers to pitch halving, pitch quartering etc. Pitch division schemes may be applicable to FEOL processing, BEOL processing, or both FEOL (device) and BEOL (metallization) processing. In accordance with one or more embodiments described herein, optical lithography is first implemented to print unidirectional lines (e.g., either strictly unidirectional or predominantly unidirectional) in a pre-defined pitch. Pitch division processing is then implemented as a technique to increase line density.

In an embodiment, the term "grating structure" for fins, gate lines, metal lines, ILD lines or hardmask lines is used herein to refer to a tight pitch grating structure. In one such embodiment, the tight pitch is not achievable directly through a selected lithography. For example, a pattern based on a selected lithography may first be formed, but the pitch may be halved by the use of spacer mask patterning, as is known in the art. Even further, the original pitch may be quartered by a second round of spacer mask patterning. Accordingly, the grating-like patterns described herein may have metal lines, ILD lines or hardmask lines spaced at a substantially consistent pitch and having a substantially consistent width. For example, in some embodiments the pitch variation would be within ten percent and the width variation would be within ten percent, and in some embodiments, the pitch variation would be within five percent and the width variation would be within five percent. The pattern may be fabricated by a pitch halving or pitch quartering, or other pitch division, approach. In an embodiment, the grating is not necessarily single pitch.

In an embodiment, a blanket film is patterned using lithography and etch processing which may involve, e.g., spacer-based-double-patterning (SBDP) or pitch halving, or spacer-based-quadruple-patterning (SBQP) or pitch quartering. It is to be appreciated that other pitch division approaches may also be implemented. In any case, in an embodiment, a gridded layout may be fabricated by a selected lithography approach, such as 193nm immersion lithography (193i). Pitch division may be implemented to increase the density of lines in the gridded layout by a factor of n. Gridded layout formation with 193i lithography plus pitch division by a factor of 'n' can be designated as 193i + P/n Pitch Division. In one such embodiment, 193nm immersion scaling can be extended for many generations with cost effective pitch division.

It is also to be appreciated that not all aspects of the processes described above need be practiced to fall within the spirit and scope of embodiments of the present disclosure. For example, in one embodiment, dummy gates need not ever be formed prior to fabricating vias to underlying contacts that have interfaces with increased surface area. The gate stacks described above may actually be permanent gate stacks as initially formed. Also, the processes described herein may be used to fabricate one or a plurality of semiconductor devices. The semiconductor devices may be transistors or like devices. For example, in an embodiment, the semiconductor devices are a metal-oxide semiconductor (MOS) transistors for logic or memory, or are bipolar transistors. Also, in an embodiment, the semiconductor devices have a three-dimensional architecture, such as a trigate device, an independently accessed double gate device, or a FIN-FET. One or more embodiments may be particularly useful for fabricating semiconductor devices at a 10 nanometer (10 nm) technology node or sub-10 nanometer (10 nm) technology node. Embodiments described herein can also be implemented for gate-all-around (GAA) architectures, such as nanowire or nanoribbon architectures.

Additional or intermediate operations for FEOL layer or structure fabrication may include standard microelectronic fabrication processes such as lithography, etch, thin films deposition, planarization (such as chemical mechanical polishing (CMP)), diffusion, metrology, the use of sacrificial layers, the use of etch stop layers, the use of planarization stop layers, or any other associated action with microelectronic component fabrication. Also, it is to be appreciated that the process operations described for the preceding process flows may be practiced in alternative sequences, not every operation need be performed or additional process operations may be performed, or both.

Embodiments disclosed herein may be used to manufacture a wide variety of different types of integrated circuits or microelectronic devices. Examples of such integrated circuits include, but are not limited to, processors, chipset components, graphics processors, digital signal processors, micro-controllers, and the like. In other embodiments, semiconductor memory may be manufactured. Moreover, the integrated circuits or other microelectronic devices may be used in a wide variety of electronic devices known in the arts. For example, in computer systems (e.g., desktop, laptop, server), cellular phones, personal electronics, etc. The integrated circuits may be coupled with a bus and other components in the systems. For example, a processor may be coupled by one or more buses to a memory, a chipset, etc. Each of the processor, the memory, and the chipset, may potentially be manufactured using the approaches disclosed herein.

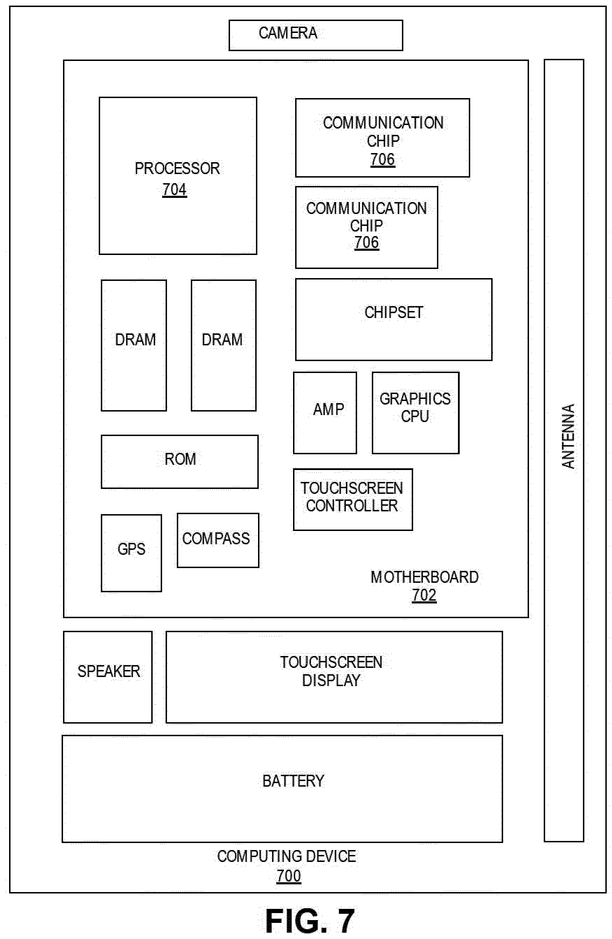

Figure 7 illustrates a computing device 700 in accordance with one implementation of the disclosure. The computing device 700 houses a board 702. The board 702 may include a number of components, including but not limited to a processor 704 and at least one communication chip 706. The processor 704 is physically and electrically coupled to the board 702. In some implementations the at least one communication chip 706 is also physically and electrically coupled to the board 702. In further implementations, the communication chip 706 is part of the processor 704.

Depending on its applications, computing device 700 may include other components that may or may not be physically and electrically coupled to the board 702. These other components include, but are not limited to, volatile memory (e.g., DRAM), non-volatile memory (e.g., ROM), flash memory, a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth).

The communication chip 706 enables wireless communications for the transfer of data to and from the computing device 700. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 706 may implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing device 700 may include a plurality of communication chips 706. For instance, a first communication chip 706 may be dedicated to shorter range wireless communications such as Wi-Fi and Bluetooth and a second communication chip 706 may be dedicated to longer range wireless communications such as GPS, EDGE, GPRS, CDMA, WiMAX, LTE, Ev-DO, and others.

The processor 704 of the computing device 700 includes an integrated circuit die packaged within the processor 704. In some implementations of embodiments of the disclosure, the integrated circuit die of the processor includes one or more structures, such as integrated circuit structures built in accordance with implementations of the disclosure. The term "processor" may refer to any device or portion of a device that processes electronic data from registers or memory to transform that electronic data, or both, into other electronic data that may be stored in registers or memory, or both.

The communication chip 706 also includes an integrated circuit die packaged within the communication chip 706. In accordance with another implementation of the disclosure, the integrated circuit die of the communication chip is built in accordance with implementations of the disclosure.

In further implementations, another component housed within the computing device 700 may contain an integrated circuit die built in accordance with implementations of embodiments of the disclosure.

In various embodiments, the computing device 700 may be a laptop, a netbook, a notebook, an ultrabook, a smartphone, a tablet, a personal digital assistant (PDA), an ultramobile PC, a mobile phone, a desktop computer, a server, a printer, a scanner, a monitor, a set-top box, an entertainment control unit, a digital camera, a portable music player, or a digital video recorder. In further implementations, the computing device 700 may be any other electronic device that processes data.

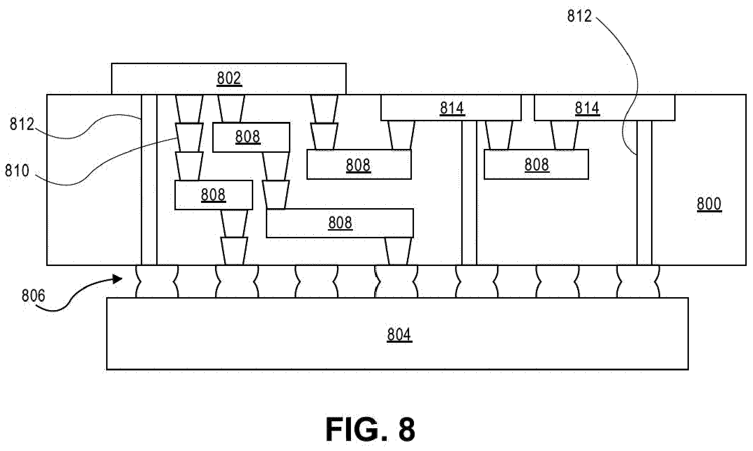

Figure 8 illustrates an interposer 800 that includes one or more embodiments of the disclosure. The interposer 800 is an intervening substrate used to bridge a first substrate 802 to a second substrate 804. The first substrate 802 may be, for instance, an integrated circuit die. The second substrate 804 may be, for instance, a memory module, a computer motherboard, or another integrated circuit die. Generally, the purpose of an interposer 800 is to spread a connection to a wider pitch or to reroute a connection to a different connection. For example, an interposer 800 may couple an integrated circuit die to a ball grid array (BGA) 806 that can subsequently be coupled to the second substrate 804. In some embodiments, the first and second substrates 802/804 are attached to opposing sides of the interposer 800. In other embodiments, the first and second substrates 802/804 are attached to the same side of the interposer 800. And in further embodiments, three or more substrates are interconnected by way of the interposer 800.

The interposer 800 may be formed of an epoxy resin, a fiberglassreinforced epoxy resin, a ceramic material, or a polymer material such as polyimide. In further implementations, the interposer 800 may be formed of alternate rigid or flexible materials that may include the same materials described above for use in a semiconductor substrate, such as silicon, germanium, and other group III-V and group IV materials.

The interposer 800 may include metal interconnects 808 and vias 810, including but not limited to through-silicon vias (TSVs) 812. The interposer 800 may further include embedded devices 814, including both passive and active devices. Such devices include, but are not limited to, capacitors, decoupling capacitors, resistors, inductors, fuses, diodes, transformers, sensors, and electrostatic discharge (ESD) devices. More complex devices such as radio-frequency (RF) devices, power amplifiers, power management devices, antennas, arrays, sensors, and MEMS devices may also be formed on the interposer 800. In accordance with embodiments of the disclosure, apparatuses or processes disclosed herein may be used in the fabrication of interposer 800 or in the fabrication of components included in the interposer 800.

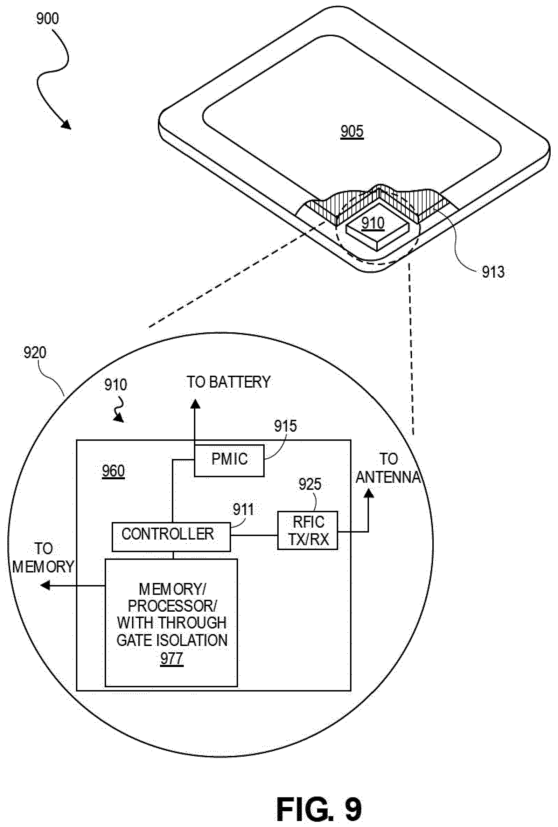

Figure 9 is an isometric view of a mobile computing platform 900 employing an integrated circuit (IC) fabricated according to one or more processes described herein or including one or more features described herein, in accordance with an embodiment of the present disclosure.

The mobile computing platform 900 may be any portable device configured for each of electronic data display, electronic data processing, and wireless electronic data transmission. For example, mobile computing platform 900 may be any of a tablet, a smart phone, laptop computer, etc. and includes a display screen 905 which in the exemplary embodiment is a touchscreen (capacitive, inductive, resistive, etc.), a chiplevel (SoC) or package-level integrated system 910, and a battery 913. As illustrated, the greater the level of integration in the system 910 enabled by higher transistor packing density, the greater the portion of the mobile computing platform 900 that may be occupied by the battery 913 or non-volatile storage, such as a solid state drive, or the greater the transistor gate count for improved platform functionality. Similarly, the greater the carrier mobility of each transistor in the system 910, the greater the functionality. As such, techniques described herein may enable performance and form factor improvements in the mobile computing platform 900.

The integrated system 910 is further illustrated in the expanded view 920. In the exemplary embodiment, packaged device 977 includes at least one memory chip (e.g., RAM), or at least one processor chip (e.g., a multi-core microprocessor and/or graphics processor) fabricated according to one or more processes described herein or including one or more features described herein. The packaged device 977 is further coupled to the board 960 along with one or more of a power management integrated circuit (PMIC) 915, RF (wireless) integrated circuit (RFIC) 925 including a wideband RF (wireless) transmitter and/or receiver (e.g., including a digital baseband and an analog front end module further includes a power amplifier on a transmit path and a low noise amplifier on a receive path), and a controller thereof 911. Functionally, the PMIC 915 performs battery power regulation, DC-to-DC conversion, etc., and so has an input coupled to the battery 913 and with an output providing a current supply to all the other functional modules. As further illustrated, in the exemplary embodiment, the RFIC 925 has an output coupled to an antenna to provide to implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. In alternative implementations, each of these board-level modules may be integrated onto separate ICs coupled to the package substrate of the packaged device 977 or within a single IC (SoC) coupled to the package substrate of the packaged device 977.

In another aspect, semiconductor packages are used for protecting an integrated circuit (IC) chip or die, and also to provide the die with an electrical interface to external circuitry. With the increasing demand for smaller electronic devices, semiconductor packages are designed to be even more compact and must support larger circuit density. Furthermore, the demand for higher performance devices results in a need for an improved semiconductor package that enables a thin packaging profile and low overall warpage compatible with subsequent assembly processing.

In an embodiment, wire bonding to a ceramic or organic package substrate is used. In another embodiment, a C4 process is used to mount a die to a ceramic or organic package substrate. In particular, C4 solder ball connections can be implemented to provide flip chip interconnections between semiconductor devices and substrates. A flip chip or Controlled Collapse Chip Connection (C4) is a type of mounting used for semiconductor devices, such as integrated circuit (IC) chips, MEMS or components, which utilizes solder bumps instead of wire bonds. The solder bumps are deposited on the C4 pads, located on the top side of the substrate package. In order to mount the semiconductor device to the substrate, it is flipped over with the active side facing down on the mounting area. The solder bumps are used to connect the semiconductor device directly to the substrate.

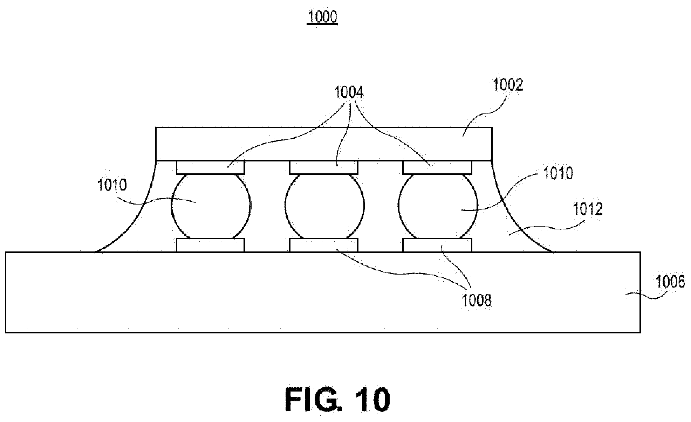

Figure 10 illustrates a cross-sectional view of a flip-chip mounted die, in accordance with an embodiment of the present disclosure.

Referring to Figure 10, an apparatus 1000 includes a die 1002 such as an integrated circuit (IC) fabricated according to one or more processes described herein or including one or more features described herein, in accordance with an embodiment of the present disclosure. The die 1002 includes metallized pads 1004 thereon. A package substrate 1006, such as a ceramic or organic substrate, includes connections 1008 thereon. The die 1002 and package substrate 1006 are electrically connected by solder balls 1010 coupled to the metallized pads 1004 and the connections 1008. An underfill material 1012 surrounds the solder balls 1010.

Processing a flip chip may be similar to conventional IC fabrication, with a few additional operations. Near the end of the manufacturing process, the attachment pads are metalized to make them more receptive to solder. This typically consists of several treatments. A small dot of solder is then deposited on each metalized pad. The chips are then cut out of the wafer as normal. To attach the flip chip into a circuit, the chip is inverted to bring the solder dots down onto connectors on the underlying electronics or circuit board. The solder is then re-melted to produce an electrical connection, typically using an ultrasonic or alternatively reflow solder process. This also leaves a small space between the chip's circuitry and the underlying mounting. In most cases an electrically-insulating adhesive is then "underfilled" to provide a stronger mechanical connection, provide a heat bridge, and to ensure the solder joints are not stressed due to differential heating of the chip and the rest of the system.

In other embodiments, newer packaging and die-to-die interconnect approaches, such as through silicon via (TSV) and silicon interposer, are implemented to fabricate high performance Multi-Chip Module (MCM) and System in Package (SiP) incorporating an integrated circuit (IC) fabricated according to one or more processes described herein or including one or more features described herein, in accordance with an embodiment of the present disclosure.

Thus, embodiments of the present disclosure include narrow conductive via structures for gate contact or trench contact, and methods of fabricating narrow conductive via structures for gate contact or trench contact.

Although specific embodiments have been described above, these embodiments are not intended to limit the scope of the present disclosure, even where only a single embodiment is described with respect to a particular feature. Examples of features provided in the disclosure are intended to be illustrative rather than restrictive unless stated otherwise. The above description is intended to cover such alternatives, modifications, and equivalents as would be apparent to a person skilled in the art having the benefit of the present disclosure.

The scope of the present disclosure includes any feature or combination of features disclosed herein (either explicitly or implicitly), or any generalization thereof, whether or not it mitigates any or all of the problems addressed herein. Accordingly, new claims may be formulated during prosecution of the present application (or an application claiming priority thereto) to any such combination of features. In particular, with reference to the appended claims, features from dependent claims may be combined with those of the independent claims and features from respective independent claims may be combined in any appropriate manner and not merely in the specific combinations enumerated in the appended claims.

The following examples pertain to further embodiments. The various features of the different embodiments may be variously combined with some features included and others excluded to suit a variety of different applications.

Example 1: an integrated circuit structure, comprising: a plurality of gate structures above a substrate; a plurality of conductive trench contact structures alternating with the plurality of gate structures; a plurality of dielectric spacers, a corresponding one of the plurality of dielectric spacers between adjacent ones of the plurality of gate structures and the plurality of conductive trench contact structures; and a plurality of conductive vias, individual ones of the plurality of conductive vias on corresponding ones of the plurality of conductive trench contact structures, wherein bottommost surfaces of the conductive vias are below topmost surfaces of the plurality of conductive trench contact structures.

Example 2: the integrated circuit structure of Example 1, wherein individual ones of the plurality of conductive trench contact structures comprise recesses, and wherein individual ones of the plurality of conductive vias fill corresponding ones of the recesses.

Example 3: the integrated circuit structure of Example 2, wherein the recesses extend into adjacent ones of the plurality of dielectric spacers.

Example 4: the integrated circuit structure of Example 3, wherein the recesses have a first depth in individual ones of the plurality of conductive trench contact structures, and wherein the recesses have a second depth in individual ones of the plurality of dielectric spacers, wherein the second depth is different than the first depth.

Example 5: the integrated circuit structure of Examples 1-4, wherein individual ones of the plurality of conductive vias wrap around a corner of corresponding ones of the plurality of conductive trench contact structures.

Example 6: the integrated circuit structure of Example 5, wherein individual ones of the plurality of conductive vias fill a recess in a neighboring dielectric spacer.

Example 7: an integrated circuit structure, comprising: a gate structure over a substrate; a conductive trench contact structure adjacent to the gate structure; a dielectric spacer between the gate structure and the conductive trench contact structure; and a conductive via over the dielectric spacer and over the conductive trench contact structure, wherein a bottommost surface of the conductive via is below a topmost surface of the conductive trench contact structure.

Example 8: the integrated circuit structure of Example 7, further comprising: a first recess in the dielectric spacer; and a second recess in the conductive trench contact structure.

Example 9: the integrated circuit structure of Example 8, wherein the first recess has a different depth than the second recess.

Example 10: the integrated circuit structure of Examples 7-9, further comprising: a recess into the dielectric spacer, wherein the conductive via fills the recess and wraps around a corner of the conductive trench contact structure.

Example 11: the integrated circuit structure of Examples 7-10, further comprising: a recess into the conductive trench contact structure, wherein the conductive via fills the recess.

Example 12: a computing device, comprising: a board; and a component coupled to the board, the component including an integrated circuit structure, comprising: a plurality of gate structures above a substrate; a plurality of conductive trench contact structures alternating with the plurality of gate structures; a plurality of dielectric spacers, a corresponding one of the plurality of dielectric spacers between adjacent ones of the plurality of gate structures and the plurality of conductive trench contact structures; and a plurality of conductive vias, individual ones of the plurality of conductive vias on corresponding ones of the plurality of conductive trench contact structures, wherein bottommost surfaces of the conductive vias are below topmost surfaces of the plurality of conductive trench contact structures.

Example 13: the computing device of Example 12, further comprising: a memory coupled to the board.

Example 14: the computing device of Example 12 or Example 13, further comprising: a communication chip coupled to the board.

Example 15: the computing device of Examples 12-14, further comprising: a camera coupled to the board.

Example 16: the computing device of Examples 12-15, wherein the component is a packaged integrated circuit die.

Example 17: a computing device, comprising: a board; and a component coupled to the board, the component including an integrated circuit structure, comprising: a gate structure over a substrate; a conductive trench contact structure adjacent to the gate structure; a dielectric spacer between the gate structure and the conductive trench contact structure; and a conductive via over the dielectric spacer and over the conductive trench contact structure, wherein a bottommost surface of the conductive via is below a topmost surface of the conductive trench contact structure.

Example 18: the computing device of Example 17, further comprising: a memory coupled to the board.

Example 19: the computing device of Example 17 or Example 18, further comprising: a communication chip coupled to the board.

Example 20: the computing device of Examples 17-19, further comprising: a camera coupled to the board.

Example 21: the computing device of Examples 17-20, wherein the component is a packaged integrated circuit die.

Example 22: the computing device of Examples 17-21, further comprising: a first recess in the dielectric spacer; and a second recess in the conductive trench contact structure.

Example 23: the computing device of claim of Example 22, wherein the first recess has a different depth than the second recess.

Example 24: the computing device of claim of Examples 17-23, further comprising: a recess into the dielectric spacer, wherein the conductive via fills the recess and wraps around a corner of the conductive trench contact structure.

Example 25: the computing device of claim of Examples 17-24, further comprising: a recess into the conductive trench contact structure, wherein the conductive via fills the recess.

## Claims

1. An integrated circuit structure, comprising:
a plurality of gate structures above a substrate;
a plurality of conductive trench contact structures alternating with the plurality of gate structures;
a plurality of dielectric spacers, a corresponding one of the plurality of dielectric spacers between adjacent ones of the plurality of gate structures and the plurality of conductive trench contact structures; and
a plurality of conductive vias, individual ones of the plurality of conductive vias on corresponding ones of the plurality of conductive trench contact structures, wherein
bottommost surfaces of the conductive vias are below topmost surfaces of the plurality of conductive trench contact structures.

2. The integrated circuit structure of claim 1, wherein individual ones of the plurality of conductive trench contact structures comprise recesses, and wherein individual ones of the plurality of conductive vias fill corresponding ones of the recesses.

3. The integrated circuit structure of claim 2, wherein the recesses extend into adjacent ones of the plurality of dielectric spacers.

4. The integrated circuit structure of claim 3, wherein the recesses have a first depth in individual ones of the plurality of conductive trench contact structures, and wherein the recesses have a second depth in individual ones of the plurality of dielectric spacers, wherein the second depth is different than the first depth.

5. The integrated circuit structure of claim 1, 2, 3 or 4, wherein individual ones of the plurality of conductive vias wrap around a corner of corresponding ones of the plurality of conductive trench contact structures.

6. The integrated circuit structure of claim 5, wherein individual ones of the plurality of conductive vias fill a recess in a neighboring dielectric spacer.

7. A method of fabricating an integrated circuit structure, the method comprising:
forming a plurality of gate structures above a substrate;
forming a plurality of conductive trench contact structures alternating with the plurality of gate structures;
forming a plurality of dielectric spacers, a corresponding one of the plurality of dielectric spacers between adjacent ones of the plurality of gate structures and the plurality of conductive trench contact structures; and
forming a plurality of conductive vias, individual ones of the plurality of conductive vias on corresponding ones of the plurality of conductive trench contact structures, wherein
bottommost surfaces of the conductive vias are below topmost surfaces of the plurality of conductive trench contact structures.

8. The method of claim 7, wherein individual ones of the plurality of conductive trench contact structures comprise recesses, and wherein individual ones of the plurality of conductive vias fill corresponding ones of the recesses.

9. The method of claim 8, wherein the recesses extend into adjacent ones of the plurality of dielectric spacers.

10. The method of claim 9, wherein the recesses have a first depth in individual ones of the plurality of conductive trench contact structures, and wherein the recesses have a second depth in individual ones of the plurality of dielectric spacers, wherein the second depth is different than the first depth.

11. The method of claim 7, 8, 9 or 10, wherein individual ones of the plurality of conductive vias wrap around a corner of corresponding ones of the plurality of conductive trench contact structures.

12. The method of claim 11, wherein individual ones of the plurality of conductive vias fill a recess in a neighboring dielectric spacer.
